# FASCICULE DE BREVET EUROPEEN

(11) **EP 2 928 349 B1**
(45) Date de publication et mention de la délivrance du brevet: **12.07.2017**
(21) Numéro de dépôt: 13795732.0
(22) Date de dépôt: 22.11.2013
(51) Int. Cl.: A47J 36/02

(54) **DISPOSITIF DE CUISSON COMPORTANT UNE SURFACE DE CUISSON FACILE A NETTOYER ET RESISTANT A LA RAYURE**
KOCHVORRICHTUNG MIT EINER EINFACH ZU REINIGENDEN UND KRATZFESTEN KOCHFLÄCHE
COOKING DEVICE COMPRISING A COOKING SURFACE THAT IS EASY TO CLEAN AND RESISTANT TO SCRATCHING

(30) Priorité: 26.11.2012 FR 1261228
(43) Date de publication de la demande: 14.10.2015
(73) Titulaire: SEB S.A., 69130 Ecully (FR); Université de Lorraine, 54052 Nancy Cedex (FR); CNRS - Centre National de la Recherche Scientifique (EPST), 75794 Paris Cedex 16 (FR)
(72) Inventeur: PIERSON, Jean-François, 88450 Vincey (FR); ALLEMAND, Simon, 74150 Rumilly (FR); MEYER, Mickaël, 74150 Rumilly (FR); TUFFE, Stéphane, 73160 Cognin (FR)
(74) Mandataire: Cémeli, Eric Philippe Laurent
(86) Numéro de dépôt international: PCT/EP2013/074505
(87) Numéro de publication internationale: WO 2014/079981

(56) Documents cités:
- EP-A1- 0 004 177
- WO-A1-2005/078044
- DE-U1-202006 002 366

## Description

La présente invention concerne le domaine technique des surfaces de cuisson utilisées dans les articles culinaires ou dans les appareils électroménagers chauffants.

La présente invention concerne plus particulièrement les dispositifs de cuisson comportant une surface de cuisson susceptible d'être exposée à des outils tranchants et/ou durs, tels que notamment couteaux, fourchettes ou spatules.

Il est connu de réaliser des dispositifs de cuisson comportant une surface de cuisson en acier inoxydable. Toutefois certains aliments adhèrent sur ces surfaces lors de la cuisson, et l'utilisation d'outils tranchants et/ou durs est susceptible de rayer ces surfaces.

L'utilisation de dépôts de nitrure de métaux de transition permet d'améliorer la résistance à la rayure des surfaces de cuisson, toutefois ces revêtements présentent une adhésion forte de certains aliments tels que les pommes de terre ou les poissons avec la surface de cuisson.

Un dispositif de cuisson selon le préambule de la revendication 1 est connu du document DE 20 2006 002366 U.

Un objet de la présente invention est de proposer un dispositif de cuisson comportant une surface de cuisson permettant de limiter ou d'éviter l'adhésion des aliments au cours de la cuisson, qui soit facile à nettoyer.

Un autre objet de la présente invention est de proposer un dispositif de cuisson comportant une surface de cuisson permettant de limiter ou d'éviter l'adhésion des aliments au cours de la cuisson, qui reste facile à nettoyer malgré de nombreuses utilisations.

Un autre objet de la présente invention est de proposer un dispositif de cuisson comportant une surface de cuisson permettant de limiter ou d'éviter l'adhésion des aliments au cours de la cuisson, qui présente une résistance à la rayure améliorée par rapport à une surface de cuisson en acier inoxydable.

Un autre objet de la présente invention est de proposer un article culinaire ou un appareil électroménager de cuisson comportant un dispositif de cuisson du type précité.

Un autre objet de la présente invention est de proposer un procédé d'obtention d'un dispositif de cuisson comportant une surface de cuisson permettant de limiter ou d'éviter l'adhésion des aliments au cours de la cuisson, qui soit facile à nettoyer.

Un autre objet de la présente invention est de proposer un procédé d'obtention d'un dispositif de cuisson comportant une surface de cuisson permettant de limiter ou d'éviter l'adhésion des aliments au cours de la cuisson, qui reste facile à nettoyer malgré de nombreuses utilisations.

Un autre objet de la présente invention est de proposer un procédé d'obtention d'un dispositif de cuisson comportant une surface de cuisson permettant de limiter ou d'éviter l'adhésion des aliments au cours de la cuisson, qui présente une résistance à la rayure améliorée par rapport à une surface de cuisson en acier inoxydable.

Ces objets sont atteints avec un dispositif de cuisson comprenant un support métallique portant une surface de cuisson céramique, le support présentant une dureté supérieure ou égale à 150 HV, du fait que le support forme un substrat portant une couche superficielle de borure de métal de transition formant la surface de cuisson, et que la couche superficielle est formée par une couche de conversion de borure de fer et/ou de titane, selon le matériau utilisé pour le support. De manière avantageuse, l'épaisseur de la couche superficielle est alors comprise entre 10 et 300 µm.

Les couches superficielles de borures de métaux de transition sont connues pour leurs propriétés de grande dureté, de résistance à l'usure et leur stabilité thermique. Des essais ont montré que de manière surprenante de telles couches superficielles présentent également des propriétés de non adhésion des aliments et de facilité de nettoyage améliorées par rapport aux surfaces de cuisson en acier inoxydable.

Ces objets sont atteints également avec un dispositif de cuisson comprenant un support métallique portant une surface de cuisson céramique, le support présentant une dureté supérieure ou égale à 150 HV, du fait que le support forme un substrat portant une couche superficielle de boronitrure de métal de transition formant la surface de cuisson.

Les propriétés de dureté du substrat permettent également d'améliorer la résistance à la rayure de la couche superficielle de borure ou de boronitrure de métal de transition.

Selon un mode de réalisation, la couche superficielle est formée par un revêtement de borure ou de boronitrure de métal de transition. De manière avantageuse, l'épaisseur de la couche superficielle est comprise entre 2 et 10 µm, et de préférence entre 3 et 5 µm.

Avantageusement alors, le métal de transition est choisi parmi le titane, le chrome, le zirconium, le vanadium, le niobium, le fer.

Avantageusement, la couche superficielle présente une épaisseur au moins égale à 2 µm, et de préférence au moins égale à 3 µm. Cette disposition permet d'obtenir une résistance à la rayure satisfaisante.

Selon une forme de réalisation préférée, le support est réalisé en acier inoxydable, en titane ou en matériau multicouches comportant au moins une face externe en acier inoxydable. Si désiré, un support métallique multimatériaux, notamment un support multicouches et/ou composite à matrice métallique, peut être envisagé.

Selon une forme de réalisation avantageuse, le support présente une face portant la surface de cuisson et une autre face opposée à ladite face. Si désiré, le support peut être obtenu par emboutissage et/ou découpe d'une tôle métallique.

Ces objets sont atteints également avec un article culinaire comportant un dispositif de cuisson comprenant un support métallique présentant une face intérieure et/ou supérieure formant une surface de cuisson et une autre face extérieure et/ou inférieure destinée à être disposée du coté d'une source de chaleur, dans lequel le dispositif de cuisson est conforme à l'une au moins des caractéristiques précitées.

Ces objets sont atteints également avec un appareil électroménager de cuisson comportant un dispositif de cuisson comprenant un support métallique présentant une face intérieure et/ou supérieure formant une surface de cuisson et une autre face extérieure et/ou inférieure portée par ledit appareil, dans lequel le dispositif de cuisson est conforme à l'une au moins des caractéristiques précitées.

Ces objets sont atteints également avec un procédé d'obtention d'un dispositif de cuisson, comprenant les étapes suivantes :
- fourniture ou réalisation d'un support métallique présentant une dureté supérieure ou égale à 150 HV,
- réalisation d'une couche superficielle de borure de métal de transition sur une face du support métallique, pour former une surface de cuisson, consistant à réaliser une couche de conversion de borure de fer ou de titane par traitement de diffusion thermochimique de boruration sur ladite face du support métallique.

Ces objets sont atteints également avec un procédé d'obtention d'un dispositif de cuisson, comprenant les étapes suivantes :
- fourniture ou réalisation d'un support métallique présentant une dureté supérieure ou égale à 150 HV,
- réalisation d'une couche superficielle de boronitrure de métal de transition sur une face du support métallique, pour former une surface de cuisson.

Selon un mode de réalisation, le procédé consiste à réaliser un revêtement de boronitrure de métal de transition sur la face du support métallique.

Avantageusement alors, le métal de transition est choisi parmi le titane, le chrome, le zirconium, le vanadium, le niobium, le fer.

Selon une forme de réalisation, le revêtement est réalisé par dépôt physique en phase vapeur sur la face du support métallique.

Alors, selon une forme de réalisation préférée permettant d'obtenir des dépôts denses adhérant au substrat, le dépôt est réalisé par pulvérisation cathodique magnétron à courant continu, de préférence à courant continu pulsé.

En alternative, le revêtement pourrait notamment être réalisé par évaporation par arc cathodique sur ladite face du support métallique.

Selon une autre forme de réalisation, le revêtement est réalisé par dépôt chimique en phase vapeur assistée plasma sur ladite face du support métallique.

Avantageusement encore, le support métallique est réalisé en acier inoxydable, en titane ou en matériau multicouches comportant au moins une face externe en acier inoxydable.

L'invention sera mieux comprise à l'étude de deux modes de réalisation, pris à titre nullement limitatif, illustrés dans les figures annexées, dans lesquelles :
- la figure 1 est une vue schématique en élévation et en coupe d'un premier exemple de réalisation d'un dispositif de cuisson selon l'invention,
- la figure 2 est une vue schématique en élévation et en coupe d'un deuxième exemple de réalisation d'un dispositif de cuisson selon l'invention,

- la figure 3 est une vue schématique en coupe d'un premier mode de réalisation d'un dispositif de cuisson selon l'invention,
- la figure 4 est une vue schématique en coupe d'un deuxième mode de réalisation d'un dispositif de cuisson selon l'invention.

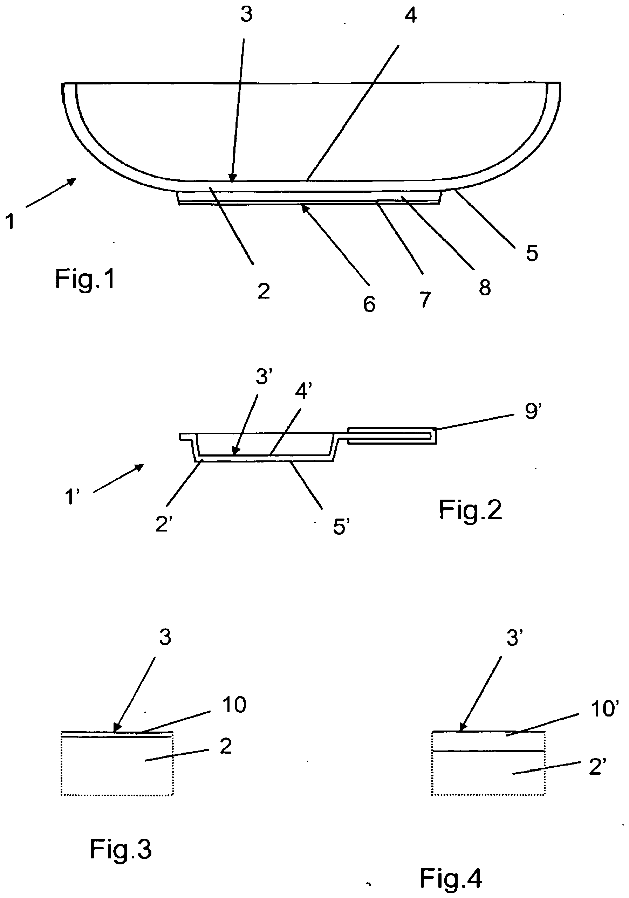

Les dispositifs de cuisson 1 ; 1' illustrés sur les figures 1 et 2 comprennent un support 2 ; 2' métallique portant une surface de cuisson 3 ; 3' céramique. Le support 2 ; 2' peut notamment présenter la forme finale d'un réceptacle de cuisson ou d'une plaque de cuisson.

Plus particulièrement, le support 2 ; 2' est obtenu à partir d'une plaque métallique et présente une face 4 ; 4' portant la surface de cuisson 3 ; 3' et une autre face 5 ; 5' opposée à la face 4 ; 4'.

Tel que représenté sur les figures 1 et 2, la surface de cuisson 3 ; 3' est concave et/ou présente un fond entouré par une paroi latérale, la face 4 ; 4' est une face intérieure du support 2 ; 2', et l'autre face 5 ; 5' est une face extérieure du support 2 ; 2'.

Le dispositif de cuisson 1 ; 1' peut notamment appartenir à un article culinaire et/ou à un appareil électroménager de cuisson.

Le dispositif de cuisson 1 illustré sur la figure 1 appartient à un article culinaire. La face 4 intérieure et/ou supérieure forme la surface de cuisson 3 et l'autre face 5 extérieure et/ou inférieure est destinée à être disposée du coté d'une source de chaleur. Un tel article culinaire peut notamment être une poêle, une casserole ou un wok, le support 2 formant une cuve. Si désiré une ou plusieurs poignées peuvent être fixées au dispositif de cuisson 1 pour former l'article culinaire.

L'autre face 5 peut présenter si désiré un fond diffuseur 6 prévu pour reposer sur un foyer de chauffe. Tel que représenté sur la figure 1, le dispositif de cuisson 1 comporte une paroi de diffusion de chaleur 7, réalisée en matériau bon conducteur de chaleur, par exemple en aluminium, agencée entre l'autre face 5 du support 2 et une paroi inférieure 8, réalisée par exemple en acier inoxydable ferromagnétique. La paroi inférieure 8 et la paroi de diffusion de chaleur 7 peuvent notamment être assemblées par frappe à chaud avec le support 2.

Le dispositif de cuisson 1' illustré sur la figure 2 peut appartenir à un appareil électroménager de cuisson tel qu'un appareil à raclette. Le support 2' forme alors une coupelle, la face 4' intérieure et/ou supérieure formant la surface de cuisson 3' et l'autre face 5' extérieure et/ou inférieure étant portée par l'appareil. Une poignée 9' peut être fixée au support 2', notamment par surmoulage ou par clipsage. La poignée 9' peut notamment être réalisée en matière plastique. Un appareil électroménager comportant un dispositif de cuisson 1' n'est toutefois pas nécessairement un appareil à raclette comportant des coupelles, mais peut notamment aussi être un appareil comportant une plaque de cuisson tel qu'une plancha, ou encore un cuiseur électrique comportant une cuve prévue pour le rissolage des aliments. Le dispositif de cuisson 1' peut être amovible ou non de l'appareil. Si désiré des moyens de chauffe peuvent être solidaires du support 2' ; l'autre face 5' extérieure et/ou inférieure n'est pas nécessairement disposée du côté d'une source de chaleur.

L'invention concerne également les articles culinaires et les appareils électroménagers de cuisson comportant un tel dispositif de cuisson 1 ; 1'.

Plus particulièrement selon l'invention, le support 2 ; 2' métallique forme un substrat portant une couche superficielle 10 ; 10' de borure ou de boronitrure de métal de transition formant la surface de cuisson 3 ; 3'.

L'expression « borure de métal de transition » n'est pas limitée aux compositions stoechiométriques comportant un atome de bore pour un atome de métal de transition, mais inclut notamment les diborures de métaux de transition. Le métal de transition est de préférence choisi parmi le titane, le chrome, le zirconium, le vanadium, le niobium, le fer. Les borures des métaux de transition tels que le titane, le chrome, le zirconium, le vanadium, le niobium sont des diborures.

L'expression « boronitrure de métal de transition » n'est pas limitée aux compositions stoechiométriques comportant un atome de bore et un atome d'azote pour un atome de métal de transition, mais inclut notamment des boronitures tel que le TiAlBN.

En d'autres termes, le support 2 ; 2' métallique forme un substrat portant une couche superficielle 10 ; 10' de borure de métal de transition ou de boronitrure de métal de transition formant la surface de cuisson 3 ; 3'.

Le support 2 ; 2' métallique est avantageusement réalisé en acier inoxydable, en titane, ou en matériau multicouches comportant au moins une face externe en acier inoxydable, par exemple un matériau sandwich acier inoxydable/aluminium/acier inoxydable.

L'épaisseur du support 2 ; 2' métallique est avantageusement comprise entre quelques dizièmes de mm et quelques mm.

Selon un premier mode de réalisation, la couche superficielle 10 est formée par un revêtement de borure ou de boronitrure de métal de transition. Le revêtement de borure de métal de transition est déposé sur un substrat formé par le support 2 ; 2' métallique.

En d'autres termes, la couche superficielle 10 est formée par un revêtement de borure de métal de transition ou de boronitrure de métal de transition.

Les techniques de revêtements peuvent notamment s'appliquer aux dispositifs de cuisson 1 ; 1' comportant des matériaux présentant une tenue en température limitée, tels que par exemple la paroi de diffusion de chaleur 7 fixée au support 2 ; la fixation de la poignée 9 du support 2' sera effectuée préférentiellement après la réalisation de la couche superficielle 10.

Les revêtements de type borures de métaux de transition tel que TiB₂, CrB₂, FeB, Fe₂B, VB₂, NbB₂ ou ZrB₂ sont connus pour leurs propriétés de grande dureté, de résistance à l'usure et à la corrosion et leur stabilité thermique.

Plusieurs procédés permettent d'obtenir des couches minces de borures de métaux de transition tels que TiB₂, CrB₂, FeB, Fe₂B, VB₂, NbB₂ ou ZrB₂. Le revêtement peut notamment être réalisé par dépôt physique en phase vapeur sur la face 4 ; 4' intérieure et/ou supérieure du support 2 ; 2', ou par dépôt chimique en phase vapeur assistée plasma sur la face 4 ; 4' intérieure et/ou supérieure du support 2 ; 2'.

Parmi les techniques de dépôt physique en phase vapeur (PVD), la pulvérisation cathodique magnétron à courant continu, pulsé ou non pulsé, semble la méthode la plus appropriée pour obtenir de tels revêtements car elle permet d'effectuer des dépôts à basse température (inférieure à 200°C) sur des pièces pouvant présenter des géométries relativement complexes sans utiliser de gaz toxique. Les dépôts obtenus sont denses et adhérents au substrat. De plus, la topographie de surface du substrat est conservée.

Les dépôts de borures de métaux de transition sont obtenus à partir d'une cible possédant la même composition que celle du revêtement visé, la cible pouvant être élaborée par frittage de poudre. Après obtention d'un vide poussé dans l'enceinte, le film est élaboré par pulvérisation en condition non-réactive sous atmosphère d'argon de la cible. Les vitesses de dépôt obtenues par cette technique sont de l'ordre de quelques µm/h.

D'autres procédés pourraient être réalisés pour obtenir des revêtements de borures de métaux de transition, tels que la pulvérisation cathodique radiofréquence, la pulvérisation cathodique en milieu réactif avec utilisation de diborane, ou encore la pulvérisation par faisceau d'ions. Toutefois, les vitesses de dépôts obtenues par ces techniques sont plus faibles qu'avec la pulvérisation cathodique magnétron.

Le revêtement pourrait aussi être réalisé par évaporation par arc cathodique sur la face 4 ; 4' intérieure et/ou supérieure du support 2 ; 2'.

Les dépôts chimiques en phase vapeur assistée plasma peuvent également permettre l'obtention de revêtement de borure de métaux de transition à relativement basse température (de l'ordre de 400°C). Par exemple, pour une couche mince de TiB₂, les gaz utilisés sont BCl₃, TiCl₄ ou Ti(BH₄)₄. Ce procédé peut permettre ainsi l'obtention de dépôts stoechiométriques possédant des propriétés proches de ceux obtenus par PVD.

Les dépôts testés ont été élaborés par technique PVD, en utilisant une pulvérisation cathodique magnétron à courant continu pulsé. Le substrat utilisé est un substrat en acier inoxydable austénitique (par exemple un acier inoxydable 304). La cible utilisée possède la même composition que le revêtement visé et est par exemple obtenue par frittage de poudre. La cible est par exemple du CrB₂ ou du TiB₂. Après obtention d'un vide poussé dans l'enceinte, la couche superficielle 10 est élaborée par pulvérisation en condition non réactive sous atmosphère d'argon.

A titre de variante, les dépôts peuvent être obtenus par copulvérisation d'une cible métallique X et d'une cible B₄C. (X désignant un métal de transition ou un alliage métallique de métaux de transitions tels que TiAl, TiCr, ZrNb..). La couche superficielle 10 comporte alors des traces de carbone.

Les revêtements de borure de métal de transition présentent une dureté élevée (> 2000 HV). Pour obtenir une résistance à la rayure satisfaisante, un substrat possédant une dureté minimale de 150 HV doit être utilisé. Ainsi, un substrat en acier inoxydable ferritique (≈ 160 HV), en acier inoxydable austénitique (≈ 210 HV) ou en titane (> 160 HV) peut être utilisé dans le cadre de cette invention. Le substrat peut comporter de l'aluminium, mais pas en tant que couche de support du revêtement, la dureté de l'aluminium (50 à 90 HV) étant insuffisante pour obtenir les propriétés souhaitées. Ainsi le support 2; 2' métallique présente une dureté supérieure ou égale à 150 HV.

La résistance à la rayure est évaluée avec un tampon abrasif de type Scotch Brite ^{®} vert (chargé avec des particules d'alumine).

Pour obtenir un revêtement résistant totalement à la rayure selon le test précité, il est nécessaire d'avoir un revêtement présentant une dureté importante ainsi qu'une épaisseur minimale de revêtement de 2,5 µm. Une épaisseur importante de revêtement, par exemple supérieure à 10 µm, n'est pas nécessaire, car les dépôts de borures sont contraints et ont tendance à fissurer. Une épaisseur de revêtement comprise entre 3 et 5 µm, par exemple 4 µm, donne des résultats satisfaisants.

Un revêtement de NbN ou de NbAlN de dureté de l'ordre de 15 GPa présente une dureté suffisante pour garantir une résistance à la rayure. La dureté des diborures de métaux de transition tels que CrB₂, TiB₂, ZrB₂ est encore supérieure. Des dépôts réalisés sur un substrat en acier inoxydable austénitique ont permis de démontrer la résistance de revêtements de CrB₂ ou de TiB₂, selon le test précité.

Les essais de facilité de nettoyage ont été effectués selon le protocole suivant : la surface à caractériser est recouverte d'un mélange de composé alimentaire présentant de fortes propriétés d'adhésion après carbonisation. Le mélange carbonisé est alors soumis à l'action d'un tampon abrasif.

Le mélange de composé alimentaire est par exemple le suivant : 34 mg/mL de glucose, 14,5 mg/mL d'amylopectine, 39 mg/mL d'ovalbumine, 13,5 mg/mL de caséine, 32,8 mg/mL d'acide linoléique. Après une cuisson au four pendant 20 min à 210°C et un refroidissement pendant 2 min, l'échantillon est immergé dans un mélange d'eau et de détergent pendant 5 min, puis nettoyé au plynomètre (appareil à abraser les résidus de cuisson). Le pourcentage de surface restant recouvert par du résidu de cuisson permet d'évaluer la facilité de nettoyage de la surface de cuisson. Un pourcentage de 0% correspond donc à une surface de cuisson possédant la facilité de nettoyage la plus importante.

Le tableau ci-dessous montre la facilité de nettoyage pour différents types de surface de cuisson 3 ; 3' : l'acier inoxydable, revêtements NbN, NbAlN (avec 59 % atomique d'Al), CrB₂.

| **Matériau de la surface de cuisson** | **% de la surface restant recouvert par le résidu de cuisson après nettoyage** | **Ecart-type** |
|---|---|---|
| **inox** | 80 | 10 |
| **NbN** | 91 | 5 |
| **NbAlN 59% Al** | 37,85 | 20 |
| **CrB₂** | 3,5 | 5 |

Il apparaît que le revêtement CrB₂ permet d'obtenir une grande facilité de nettoyage par rapport à une surface de cuisson en acier inoxydable ou avec un revêtement NbN ou NbAlN.

Un test similaire avec un autre mélange (lait + riz) a permis de confirmer ces résultats de facilité de nettoyage des revêtements de borures de métal de transition.

Les essais d'adhésion pendant la cuisson ont été effectués dans une poêle selon le protocole suivant : préchauffage de la poêle pendant 1 min 30 s avec 20 ml d'huile sur foyer gaz 40 mm à feu vif, introduction de pommes de terre de variété Charlotte à chair ferme découpées en dés, mélange des pommes de terre toutes les deux minutes, estimation des propriétés d'adhésion.

Les résultats obtenus sont les suivants : pour l'inox et le NbN, quelques résidus après cuisson et avant nettoyage (pas de différences significatives d'adhésion) ; pour le NBAlN, accroche moindre ; pour le CrB₂ et le TiB₂, aucun résidu après cuisson. De plus il a été remarqué que l'huile polymérisée s'enlève facilement sur le CrB₂ et le TiB₂.

Le dispositif de cuisson 1 ; 1' comportant un revêtement selon l'invention présente des propriétés de facilité de nettoyage significativement supérieures à celles d'une surface de cuisson en acier inoxydable, et de plus une résistance à la rayure améliorée par rapport à une surface de cuisson en acier inoxydable.

A titre de variante, des dépôts de boronitrures de métaux de transition de type XBN, par exemple TiBN ou TiAlBN, peuvent être obtenus par plusieurs voies, par exemple soit directement à partir d'une cible XBN, la couche superficielle 10 étant élaborée en pulvérisation en condition non réactive sous atmosphère d'argon, soit à partir d'une cible XB ou XB₂, la couche superficielle 10 étant déposée sous condition réactive. Les boronitrures permettent d'obtenir une couleur différente de l'acier inoxydable, par exemple gris foncé ou anthracite pour le TiBN.

Selon un deuxième mode de réalisation, la couche superficielle 10 ; 10' est formée par une couche de conversion de borure de fer ou de titane. La couche de conversion est réalisée par traitement de diffusion thermochimique de boruration sur un substrat métallique formé par le support 2 ; 2'. Une telle réalisation apparait bien adaptée au support 2' du dispositif de cuisson 1' avant la fixation de la poignée 9', mais peut également être envisagée pour le support 2 du dispositif de cuisson 1 en l'absence d'un fond diffuseur 6 comportant une paroi de diffusion de chaleur 7 en aluminium.

Les traitements de diffusion thermochimiques tels que la boruration permettent d'enrichir la surface d'une pièce en bore. Ces traitements sont usuellement réalisés entre 800 et 1000°C. Des couches homogènes de borures fortement adhérentes sont ainsi formées en surface. Différents procédés peuvent être utilisés pour réaliser de tels traitements. En milieu gazeux, les gaz sources de bore sont des halogénures de bore ou des boranes. En milieu liquide, en présence de sels fondus avec ou sans électrolyse, ou en solution aqueuse de borax. En milieu solide, par méthode de type cémentation en caisse, dans laquelle les pièces sont placées dans un cément constitué par de la poudre et des granules à base de carbure de bore auquel est mélangé un fluoroborate jouant le rôle d'activateur. La température (de l'ordre de 900°C) et le temps de traitement dépendent de l'épaisseur de la zone borurée souhaitée. Typiquement, les épaisseurs de couches borurées varient entre 10 et 300 µm. Les duretés atteintes dépendent du matériau utilisé. L'une des applications les plus courantes concernent les alliages ferreux (et notamment les aciers inoxydables) dont la dureté peut atteindre de 1600 à 2000 HV. Il est également possible de réaliser un tel traitement thermochimique de boruration sur des métaux comme le titane (formation de couche de borure de titane pouvant atteindre les 4000 HV) ou d'alliages base nickel (jusqu'à 2800 HV).

L'invention concerne également un procédé d'obtention d'un dispositif de cuisson 1, comprenant les étapes suivantes :
- fourniture ou réalisation d'un support 2 ; 2' métallique présentant une dureté supérieure ou égale à 150 HV,
- réalisation d'une couche superficielle 10 ; 10' de borure ou de boronitrure de métal de transition sur une face 4 ; 4' du support 2 ; 2' métallique, pour former une surface de cuisson 3 ; 3'.

En d'autres termes, l'invention concerne également un procédé d'obtention d'un dispositif de cuisson 1 comprenant les étapes suivantes :
- fourniture ou réalisation d'un support 2 ; 2' métallique présentant une dureté supérieure ou égale à 150 HV,
- réalisation d'une couche superficielle 10 ; 10' de borure de métal de transition ou de boronitrure de métal de transition sur une face 4 ; 4' du support 2 ; 2' métallique, pour former une surface de cuisson 3 ; 3'.

Selon le premier mode de réalisation, le procédé consiste à réaliser un revêtement de borure ou de boronitrure de métal de transition sur la face 4 ; 4' du support 2 ; 2'.

En d'autres termes, selon le premier mode de réalisation, le procédé consiste à réaliser un revêtement de borure de métal de transition ou de boronitrure de métal de transition sur la face 4 ; 4' du support 2 ; 2'.

Selon le deuxième mode de réalisation, le procédé consiste à réaliser une couche de conversion de borure de fer ou de titane par traitement de diffusion thermochimique de boruration sur la face 4 ; 4' du support 2 ; 2'.

Ainsi la surface de cuisson 3 ; 3' formée par une couche superficielle 10 ; 10' de borure ou de boronitrure de métal de transition est portée par un substrat suffisamment dur pour favoriser une bonne résistance à la rayure de la surface de cuisson 3 ; 3'. L'épaisseur de la couche superficielle 10 ; 10' est de préférence au moins égale à 2 µm, et peut atteindre 300 µm pour une couche de conversion.

La présente invention n'est nullement limitée aux exemples de réalisation décrits, mais englobe de nombreuses modifications dans le cadre des revendications.

## Revendications

1. Dispositif de cuisson (1 ; 1') comprenant un support (2; 2') métallique portant une surface de cuisson (3 ; 3') céramique, le support (2 ; 2') présentant une dureté supérieure ou égale à 150 HV, **caractérisé en ce que** le support (2 ; 2') forme un substrat portant une couche superficielle (10 ; 10') de borure de métal de transition formant la surface de cuisson (3 ; 3'), et **en ce que** la couche superficielle (10') est formée par une couche de conversion de borure de fer et/ou de titane.

2. Dispositif de cuisson (1 ; 1') comprenant un support (2; 2') métallique portant une surface de cuisson (3 ; 3') céramique, le support (2 ; 2') présentant une dureté supérieure ou égale à 150 HV, **caractérisé en ce que** le support (2 ; 2') forme un substrat portant une couche superficielle (10 ; 10') de boronitrure de métal de transition formant la surface de cuisson (3 ; 3').

3. Dispositif de cuisson (1 ; 1') selon la revendication 2, **caractérisé en ce que** la couche superficielle (10) est formée par un revêtement de boronitrure de métal de transition.

4. Dispositif de cuisson (1 ; 1') selon l'une des revendications 2 ou 3, **caractérisé en ce que** le métal de transition est choisi parmi le titane, le chrome, le zirconium, le vanadium, le niobium, le fer.

5. Dispositif de cuisson (1 ; 1') selon l'une des revendications 1 à 4, **caractérisé en ce que** la couche superficielle (10; 10') présente une épaisseur au moins égale à 2 µm, et de préférence au moins égale à 3 µm.

6. Dispositif de cuisson (1 ; 1') selon l'une des revendications 1 à 5, **caractérisé en ce que** le support (2 ; 2') est réalisé en acier inoxydable, en titane, ou en matériau multicouches comportant au moins une face externe en acier inoxydable.

7. Dispositif de cuisson (1 ; 1') selon l'une des revendications 1 à 6, **caractérisé en ce que** le support (2 ; 2') présente une face (4 ; 4') portant la surface de cuisson (3 ; 3') et une autre face (5 ; 5') opposée à la face (4 ; 4').

8. Article culinaire comportant un dispositif de cuisson (1) comprenant un support (2) métallique présentant une face (4) intérieure et/ou supérieure formant une surface de cuisson (3) et une autre face (5) extérieure et/ou inférieure destinée à être disposée du coté d'une source de chaleur, **caractérisé en ce que** le dispositif de cuisson (1) est conforme à l'une des revendications 1 à 7.

9. Appareil électroménager de cuisson comportant un dispositif de cuisson (1') comprenant un support (2') métallique présentant une face (4') intérieure et/ou supérieure formant une surface de cuisson (3') et une autre face (5') extérieure et/ou inférieure portée par ledit appareil, **caractérisé en ce que** le dispositif de cuisson (1') est conforme à l'une des revendications 1 à 7.

10. Procédé d'obtention d'un dispositif de cuisson (1 ; 1'), comprenant les étapes suivantes :
- fourniture ou réalisation d'un support (2 ; 2') métallique présentant une dureté supérieure ou égale à 150 HV,
- réalisation d'une couche superficielle (10 ; 10') de borure de métal de transition sur une face (4 ; 4') du support (2 ; 2') métallique, pour former une surface de cuisson (3 ; 3'), consistant à réaliser une couche de conversion de borure de fer ou de titane par traitement de diffusion thermochimique de boruration sur ladite face (4 ; 4') du support (2 ; 2') métallique.

11. Procédé d'obtention d'un dispositif de cuisson (1 ; 1'), comprenant les étapes suivantes :
- fourniture ou réalisation d'un support (2 ; 2') métallique présentant une dureté supérieure ou égale à 150 HV,
- réalisation d'une couche superficielle (10 ; 10') de boronitrure de métal de transition sur une face (4 ; 4') du support (2 ; 2') métallique, pour former une surface de cuisson (3 ; 3').

12. Procédé d'obtention d'un dispositif de cuisson selon la revendication 11, **caractérisé en ce qu'**il consiste à réaliser un revêtement de boronitrure de métal de transition sur ladite face (4 ; 4') du support (2 ; 2') métallique.

13. Procédé d'obtention d'un dispositif de cuisson selon l'une des revendications 11 ou 12, **caractérisé en ce que** le métal de transition est choisi parmi le titane, le chrome, le zirconium, le vanadium, le niobium, le fer.

14. Procédé d'obtention d'un dispositif de cuisson selon l'une des revendications 11 à 13, **caractérisé en ce que** le revêtement est réalisé par dépôt physique en phase vapeur sur ladite face (4 ; 4') du support (2 ; 2') métallique.

15. Procédé d'obtention d'un dispositif de cuisson selon la revendication 14, **caractérisé en ce que** le dépôt est réalisé par pulvérisation cathodique magnétron à courant continu, de préférence à courant continu pulsé.

16. Procédé d'obtention d'un dispositif de cuisson selon l'une des revendications 11 à 13, **caractérisé en ce que** le revêtement est réalisé par dépôt chimique en phase vapeur assistée plasma sur ladite face (4 ; 4') du support (2 ; 2') métallique.

17. Procédé d'obtention d'un dispositif de cuisson selon l'une des revendication 10 à 16, **caractérisé en ce que** le support (2 ; 2') métallique est réalisé en acier inoxydable ou en titane, ou en matériau multicouches comportant au moins une face externe en acier inoxydable.

## Patentansprüche

1. Vorrichtung zum Kochen (1; 1'), die einen metallischen Träger (2; 2') umfasst, der eine keramische Kochfläche (3; 3') trägt, wobei der Träger (2; 2') eine Härte größer oder gleich 150 HV aufweist, **dadurch gekennzeichnet, dass** der Träger (2; 2') ein Substrat bildet, das eine Oberflächenschicht (10; 10') aus Borid eines Übergangsmetalls trägt, das die Kochfläche (3; 3') bildet, und dass die oberflächliche Schicht (10') durch eine Umwandlungsschicht aus Eisen und/oder Titan gebildet ist.

2. Vorrichtung zum Kochen (1; 1'), die einen metallischen Träger (2; 2') umfasst, der eine keramische Kochfläche (3; 3') trägt, wobei der Träger (2; 2') eine Härte größer oder gleich 150 HV aufweist, **dadurch gekennzeichnet, dass** der Träger (2; 2') ein Substrat bildet, das eine Oberflächenschicht (10; 10') aus Bornitrid eines Übergangsmetalls trägt, das die Kochfläche (3; 3') bildet.

3. Vorrichtung zum Kochen (1; 1') nach Anspruch 2, **dadurch gekennzeichnet, dass** die Oberflächenschicht (10) durch eine Beschichtung aus Bornitrid eines Übergangsmetalls gebildet ist.

4. Vorrichtung zum Kochen (1; 1') nach Anspruch 2 oder 3, **dadurch gekennzeichnet, dass** das Übergangsmetall ausgewählt ist aus Titan, Chrom, Zirkonium, Vanadium, Niob, Eisen.

5. Vorrichtung zum Kochen (1; 1') nach einem der Ansprüche 1 bis 4, **dadurch gekennzeichnet, dass** die Oberflächenschicht (10; 10') eine Dicke von mindestens gleich 2 µm und vorzugsweise mindestens gleich 3 µm aufweist.

6. Vorrichtung zum Kochen (1; 1') nach einem der Ansprüche 1 bis 5, **dadurch gekennzeichnet, dass** der Träger (2; 2') aus Edelstahl, Titan oder einem Mehrschichtmaterial gefertigt ist, das mindestens eine Außenfläche aus Edelstahl aufweist.

7. Vorrichtung zum Kochen (1; 1') nach einem der Ansprüche 1 bis 6, **dadurch gekennzeichnet, dass** der Träger (2; 2') eine Fläche (4; 4'), die die Kochfläche (3; 3') trägt, und eine andere Fläche (5; 5') gegenüber der Fläche (4; 4') aufweist.

8. Kochgerät, das eine Vorrichtung zum Kochen (1) aufweist, die einen metallischen Träger (2) umfasst, der eine innere und/oder obere Fläche (4), die eine Kochfläche (3) bildet, und eine andere äußere und/oder untere Fläche (5) aufweist, die dazu bestimmt ist, seitlich an einer Wärmequelle angeordnet zu werden, **dadurch gekennzeichnet, dass** die Vorrichtung zum Kochen (1) gemäß einem der Ansprüche 1 bis 7 ist.

9. Kochgerät, das eine Vorrichtung zum Kochen (1') aufweist, die einen metallischen Träger (2') umfasst, der eine innere und/oder obere Fläche (4'), die eine Kochfläche (3') bildet, und eine andere äußere und/oder untere Fläche (5') aufweist, die von dem Gerät getragen wird, **dadurch gekennzeichnet, dass** die Vorrichtung zum Kochen (1') gemäß einem der Ansprüche 1 bis 7 ist.

10. Verfahren zum Erhalten einer Vorrichtung zum Kochen (1; 1'), welches die folgenden Schritte umfasst:
- Bereitstellung oder Herstellung eines metallischen Trägers (2; 2'), der eine Härte aufweist, die größer als oder gleich 150 HV ist,
- Herstellung eine Oberflächenschicht (10; 10') aus Borid eines Übergangsmetalls auf einer Fläche (4; 4') des metallischen Trägers (2; 2'), um eine Kochfläche (3; 3') zu bilden, was darin besteht, eine Umwandlungsschicht von Eisen- oder Titanborid durch eine thermochemische Diffusionsbehandlung des Borierens auf der Fläche (4; 4') des metallischen Trägers (2; 2') zu bilden.

11. Verfahren zum Erhalten einer Vorrichtung zum Kochen (1; 1'), welches die folgenden Schritte umfasst:
- Bereitstellung oder Herstellung eines metallischen Trägers (2; 2'), der eine Härte aufweist, die größer als oder gleich 150 HV ist,
- Herstellung eine Oberflächenschicht (10; 10') aus Bornitrid eines Übergangsmetalls auf einer Fläche (4; 4') des metallischen Trägers (2; 2'), um eine Kochfläche (3; 3') zu bilden.

12. Verfahren zum Erhalten einer Vorrichtung zum Kochen nach Anspruch 11, **dadurch gekennzeichnet, dass** es darin besteht, eine Beschichtung aus einem Bornitrid eines Übergangsmetalls auf der Fläche (4; 4') des metallischen Trägers (2; 2') zu bilden.

13. Verfahren zum Erhalten einer Vorrichtung zum Kochen nach einem der Ansprüche 11 oder 12, **dadurch gekennzeichnet, dass** das Übergangsmetall aus Titan, Chrom, Zirkonium, Vanadium, Niob, Eisen ausgewählt ist.

14. Verfahren zum Erhalten einer Vorrichtung zum Kochen nach einem der Ansprüche 11 bis 13, **dadurch gekennzeichnet, dass** die Beschichtung durch physikalische Dampfabscheidung auf der Fläche (4; 4') des metallischen Trägers (2; 2') gebildet ist.

15. Verfahren zum Erhalten einer Vorrichtung zum Kochen nach Anspruch 14, **dadurch gekennzeichnet, dass** die Abscheidung durch kathodisches Magnetronsputtern mit Gleichstrom, vorzugsweise gepulstem Gleichstrom, durchgeführt wird.

16. Verfahren zum Erhalten einer Vorrichtung zum Kochen nach einem der Ansprüche 11 bis 13, **dadurch gekennzeichnet, dass** die Beschichtung durch eine plasmaunterstützte chemische Dampfabscheidung auf der Fläche (4; 4') des metallischen Trägers (2; 2') erzeugt wird.

17. Verfahren zum Erhalten einer Vorrichtung zum Kochen nach einem der Ansprüche 10 bis 16, **dadurch gekennzeichnet, dass** der metallische Träger (2; 2') aus Edelstahl oder aus Titan oder einem mehrschichtigen Material hergestellt ist, das mindestens eine äußere Fläche aus Edelstahl umfasst.

## Claims

1. Cooking device (1; 1') comprising a metal holder (2; 2') supporting a ceramic cooking surface (3; 3'), with the holder (2; 2') having a hardness greater than or equal to 150 HV, **characterised in that** the holder (2; 2') forms a substrate supporting a surface layer (10; 10') of transition metal boride forming the cooking surface (3; 3'), and **in that** the surface layer (10') is formed by a conversion layer of iron and/or titanium boride.

2. Cooking device (1; 1') comprising a metal holder (2; 2') supporting a ceramic cooking surface (3; 3'), with the holder (2; 2') having a hardness greater than or equal to 150 HV, **characterised in that** the holder (2; 2') forms a substrate supporting a surface layer (10; 10') of transition metal boronitride forming the cooking surface (3; 3').

3. Cooking device (1; 1') according to claim 2, **characterised in that** the surface layer (10) is formed by a transition metal boronitride coating.

4. Cooking device (1; 1') according to one of claims 2 or 3, **characterised in that** the transition metal is chosen from titanium, chromium, zirconium, vanadium, niobium, iron.

5. Cooking device (1; 1') according to one of claims 1 to 4, **characterised in that** the surface layer (10; 10') has a thickness at least equal to 2 µm, and preferably at least equal to 3 µm.

6. Cooking device (1; 1') according to one of claims 1 to 5, **characterised in that** the holder (2; 2') is made of stainless steel, titanium, or multilayer material comprising at least one external stainless steel face.

7. Cooking device (1; 1') according to one of claims 1 to 6, **characterised in that** the holder (2; 2') has a face (4; 4') supporting the cooking surface (3; 3') and another face (5; 5') opposite the face (4; 4').

8. Culinary article comprising a cooking device (1) comprising a metal holder (2) having an internal and/or upper face (4) forming a cooking surface (3) and another external and/or lower face (5) intended to be placed next to a heat source, **characterised in that** the cooking device (1) is in accordance with one of claims 1 to 7.

9. Household cooking appliance comprising a cooking device (1') comprising a metal holder (2') having an internal and/or upper face (4') forming a cooking surface (3') and another external and/or lower face (5') supported by said appliance, **characterised in that** the cooking device (1') is in accordance with one of claims 1 to 7.

10. Method for obtaining a cooking device (1; 1'), comprising the following steps:
- supplying or carrying out a metal holder (2; 2') having a hardness greater than or equal to 150 HV,
- carrying out a surface layer (10; 10') of transition metal boride on a face (4; 4') of the metal holder (2; 2'), in order to form a cooking surface (3; 3'), consisting in carrying out a conversion layer of iron or titanium boride by boriding thermochemical diffusion treatment on said face (4; 4') of the metal holder (2; 2').

11. Method for obtaining a cooking device (1; 1'), comprising the following steps:
- supplying or carrying out a metal holder (2; 2') having a hardness greater than or equal to 150 HV,
- carrying out a surface layer (10; 10') of transition metal boronitride on a face (4; 4') of the metal holder (2; 2'), in order to form a cooking surface (3; 3').

12. Method for obtaining a cooking device according to claim 11, **characterised in that** it consists in carrying out a transition metal boronitride coating on said face (4; 4') of the metal holder (2; 2').

13. Method for obtaining a cooking device according to one of claims 11 or 12, **characterised in that** the transition metal is chosen from titanium, chromium, zirconium, vanadium, niobium, iron.

14. Method for obtaining a cooking device according to one of claims 11 to 13, **characterised in that** the coating is achieved by vapour phase physical deposition on said face (4; 4') of the metal holder (2; 2').

15. Method for obtaining a cooking device according to claim 14, **characterised in that** the deposition is carried out by direct current cathode magnetron sputtering, preferably with pulsed direct current.

16. Method for obtaining a cooking device according to one of claims 11 to 13, **characterised in that** the coating is achieved by plasma-assisted chemical vapour deposition on said face (4; 4') of the metal holder (2; 2').

17. Method for obtaining a cooking device according to one of claims 10 to 16, **characterised in that** the metal holder (2; 2') is made of stainless steel or of titanium, or of a multilayer material comprising at least one external stainless steel face.
